# FASCICULE DE BREVET EUROPEEN

(11) **EP 0 730 328 B1**
(45) Date de publication et mention de la délivrance du brevet: **14.10.1998**
(21) Numéro de dépôt: 96400410.5
(22) Date de dépôt: 27.02.1996
(51) Int. Cl.: H01S 3/06

(54) **Amplificateur optique à fibre à pompage bidirectionnel**
Zweiseitig gepumpter faseroptischer Verstärker
Fiber optic amplifier with bidirectional pumping

(30) Priorité: 28.02.1995 FR 9502298
(43) Date de publication de la demande: 04.09.1996
(73) Titulaire: Alcatel Alsthom Compagnie Generale d'Electricité, 75088 Paris (FR)
(72) Inventeur: Chesnoy, Jose, 75014 Paris (FR)
(74) Mandataire: Fournier, Michel

(56) Documents cités:
- EP-A- 0 459 685
- EP-A- 0 522 201
- US-A- 5 140 456
- IEEE PHOTONICS TECHNOLOGY LETTERS, vol. 6, no. 8, 1908 - 1994, NEW YORK US, pages 907-909, XP000465479 C.R. GILES ET AL.: "Simultaneous wavelength-stabilization of 980-nm pump laser"

## Description

La présente invention concerne un amplificateur optique à fibre à pompage bidirectionnel.

Un amplificateur selon cette invention comporte les éléments connus suivants :
- Une fibre amplificatrice s'étendant entre deux extrémités pour recevoir, guider, amplifier et transmettre des signaux optiques à amplifier.
- Deux pompes comportant chacune une cavité résonante contenant une structure à émission stimulée pour engendrer une onde de pompe. La bande spectrale occupée par une telle onde de pompe est choisie pour permettre un pompage de la fibre amplificatrice et elle constitue une bande de pompage. Les pompes sont typiquement constituées par des diodes laser semiconductrices.
- Et deux fibres d'injection de pompe associées aux deux pompes pour injecter les deux ondes de pompe dans les deux extrémités de la fibre amplificatrice par l'intermédiaire de deux multiplexeurs, respectivement.

Une instabilité des amplificateurs connus peut être provoquée par le fait que l'onde émise par chaque pompe n'est pas entièrement absorbée dans la fibre amplificatrice et vient alors perturber le fonctionnement de l'autre pompe.

Il est connu d'éviter une telle instabilité en plaçant un isolateur sur le chemin optique de chacune des pompes. Dans le même but il a été proposé d'utiliser deux pompes constituées de matériaux différents pour fonctionner l'une à une longueur d'onde de 1480 nm, l'autre à une longueur d'onde de 980 nm.

La fabrication de l'amplificateur est alors coûteuse.

La présente invention a notamment pour but d'éviter efficacement une telle instabilité tout en abaissant le coût de fabrication de l'amplificateur.

Selon cette invention chaque fibre d'injection de pompe inclut un filtre de pompe photoréfractif constituant partiellement la cavité résonnante de la pompe associée, les deux filtres de pompe présentant une différence mutuelle pour entraîner un décalage entre les deux bandes de pompage.

On peut remarquer qu'il a déjà été proposé d'insérer un filtre photoréfractif dans une fibre d'injection de pompe d'un amplificateur à fibre optique. Il s'agissait cependant d'un amplificateur à pompage unidirectionnel. Le but était d'empêcher que l'échauffement de la pompe provoque une dérive de la bande de pompage.

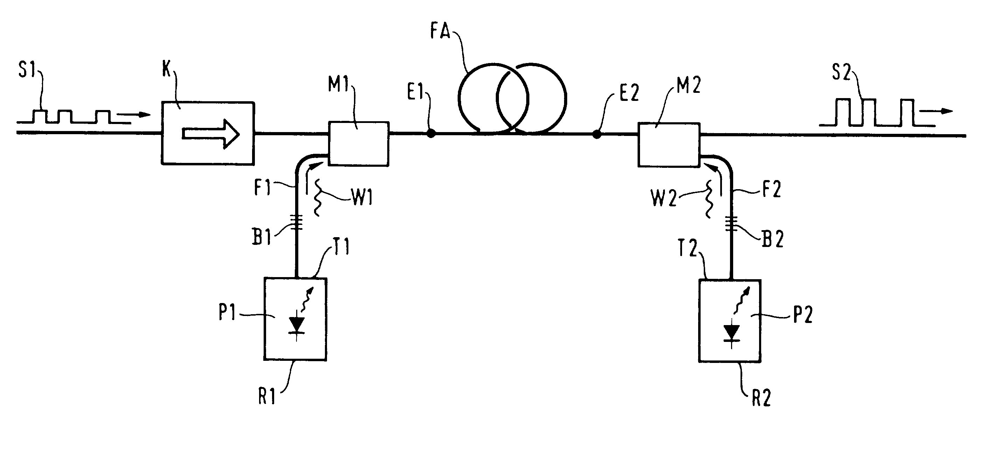

A l'aide de la figure schématique ci-jointe, on va décrire plus particulièrement ci-après, à titre d'exemple non limitatif, comment la présente invention peut être mise en oeuvre.

Cette figure représente un amplificateur selon cette invention.

On y voit : la fibre amplificatrice FA s'étendant entre deux extrémités E1 et E2, les deux pompes P1 et P2 engendrant les deux ondes de pompe W1 et W2, les fibres d'injection de pompe F1 et F2, les multiplexeurs M1 et M2 raccordant ces fibres à la fibre amplificatrice, et les filtres de pompe B1 et B2.

Un signal d'entrée S1 est injecté dans la fibre FA à travers un isolateur optique K et le multiplexeur M1 en série, cet isolateur pouvant être placé en amont ou en aval de ce multiplexeur. Après amplification dans cette fibre il donne naissance à un signal de sortie S2 plus puissant qui est fourni à travers le multiplexeur M2.

De préférence le milieu à émission stimulé de chaque pompe P1 ou P2 est limité entre d'une part une face de sortie T1 ou T2 raccordant ce milieu à la fibre d'injection de pompe F1 ou F2 associée à cette pompe, d'autre part une face de réflexion R1 ou R2 présentant une réflectance plus forte que cette face de sortie. Ces réflectances et les paramètres du filtre de pompe sont choisis pour qu'une cavité résonnante de cette pompe se constitue entre cette face de réflexion et le filtre de pompe B1 ou B2 formé dans cette fibre d'injection et impose au moins partiellement la position et la largeur de la bande de pompage.

De préférence les deux bandes de pompage sont mutuellement séparées d'une valeur de plusieurs nanomètres. Par rapport à la disposition connue précédemment indiquée cette séparation est facilitée pour les raisons suivantes :

Il est relativement facile de réaliser un réseau photo-réfractif avec un pas prédéterminé donc avec une longueur d'onde centrale de réflexion prédéterminée. Il est facile de lui donner un contraste d'indice de réfraction et une longueur prédéterminées donc une largeur de bande spectrale de réflexion prédéterminée. L'emploi d'un tel réseau permet ainsi à la fois de diminuer la largeur de la bande de pompage et de positionner plus précisément cette bande dans le spectre.

Typiquement chaque pompe est constituée par une diode laser semiconductrice pourvue d'une fibre amorce ou "queue de cochon" qui est incluse dans la fibre d'injection de pompe. C'est de préférence dans cette fibre amorce que l'on réalise un filtre photo réfractif.

Les pompes sont par exemple constituée par des diodes laser à base de InP pour fonctionner autour de 1.480 nm, ou à base de GaAs pour fonctionner autour de 980 nm.

## Revendications

1. Amplificateur optique à fibre à pompage bidirectionnel, cet amplificateur comportant :
- une fibre amplificatrice (FA) s'étendant entre deux extrémités (E1, E2) pour recevoir, guider, amplifier et transmettre des signaux optiques à amplifier (S),
- deux pompes (P1, P2) comportant deux cavités résonantes contenant deux structures à émission stimulée mutuellement identiques pour engendrer deux ondes de pompe (W1, W2) aptes à pomper la fibre amplificatrice, respectivement,
- et deux fibres d'injection de pompe (F1, F2) associées aux deux pompes pour injecter les deux ondes de pompe dans les deux extrémités (E1, E2) de la fibre amplificatrice, respectivement,
cet amplificateur étant caractérisé par le fait que chaque fibre d'injection de pompe (F1, F2) inclut un filtre de pompe (B1, B2) photoréfractif constituant partiellement ladite cavité résonnante de la pompe associée, les deux filtres de pompe présentant une différence mutuelle pour entraîner un décalage entre deux bandes spectrales occupées par les deux ondes de pompe et constituant deux bandes de pompage, respectivement.

2. Amplificateur selon la revendication 1, les deux filtres de pompe entraînant une séparation entre les deux bandes de pompage.

3. Amplificateur selon la revendication 1, le milieu à émission stimulé de chaque pompe (P1, P2) étant limité entre d'une part une face de sortie (T1, T2) raccordant ce milieu à la fibre d'injection de pompe (F1, F2) associée à cette pompe, d'autre part une face de réflexion (R1, R2) présentant une réflectance plus forte que cette face de sortie.

4. Amplificateur selon la revendication 3, la structure à émission stimulée de chaque pompe (P1, P2) étant constituée par une diode laser semiconductrice, cette diode étant pourvue d'une fibre amorce dans laquelle le filtre de cette pompe (B1, B2) est réalisé.

## Patentansprüche

1. Zweiseitig gepumpter faseroptischer Verstärker, der aufweist:
- eine verstärkerfaser (FA), die sich zwischen zwei Enden (E1, E2) erstreckt, zum Empfangen, Führen, Verstärken und Übertragen von zu verstärkenden optischen Signalen (S),
- zwei Pumpen (P1, P2), die zwei Hohlraumresonatoren umfassen, die zwei wechselseitig gleiche, angeregte Sendeaufbauten zum Erzeugen zweier Pumpenwellen (W1, W2) umfassen, die jeweils fähig sind, die Verstärkerfaser zu pumpen,
- und zwei Pumpen-Einkopplungsfasern (F1, F2), die mit den beiden Pumpen verbunden sind, um die beiden Pumpenwellen entsprechend in die beiden Enden (E1, E2) der Verstärkerfaser einzukoppeln,
**dadurch gekennzeichnet,** daß jede Pumpen-Einkopplungsfaser (F1, F2) einen lichtbrechenden Pumpenfilter (B1, B2) beinhaltet, der teilweise den Holraumresonator der zugehörigen Pumpe bildet, wobei die beiden Pumpenfilter einen Unterschied aufweisen, um eine Verschiebung zwischen zwei Spektralbanden zu erzeugen, die von den beiden Pumpenwellen eingenommen werden und zwei Pumpbanden bilden.

2. Verstärker nach Anspruch 1, wobei die beiden Pumpenfilter eine Trennung zwischen den beiden Pumpbanden bewirken.

3. Verstärker nach Anspruch 1, wobei das angeregte Sendemittelstück jeder Pumpe (P1, P2) zwischen einerseits einer Ausgangsseite (T1, T2), die dieses Mittelstück mit der zu dieser Pumpe gehörigen Pumpen-Einkopplungsfaser (F1, F2) verbindet, anderseits einer Reflexionsseite (R1, R2) begrenzt ist, die einen stärkeren Reflexionsgrad als diese Ausgangsseite aufweist.

4. Verstärker nach Anspruch 3, wobei der angeregte Sendeaufbau jeder Pumpe (P1, P2) aus einer Halbleiter-Laserdiode besteht, wobei diese Diode mit einer Anschlußfaser versehen ist, in der der Filter dieser Pumpe (B1, B2) ausgeführt ist.

## Claims

1. An optical fiber amplifier with both-way pumping, the amplifier comprising:
• an amplifying fiber (FA) extending between two ends (E1, E2) to receive, guide, amplify, and transmit optical signals (S) to be amplified;
• two pumps (P1, P2) including two resonant cavities containing two mutually identical stimulated emission structures for generating two respective pump waves (W1, W2) suitable for pumping the amplifying fiber: and
• two pump injection fibers (F1, F2) associated with the two pumps to inject the two pump waves into respective ones of the two ends (El, E2) of the amplifying fiber,
the amplifier being characterized by the fact that each pump injection fiber (F1, F2) includes a respective photorefractive pump filter (B1, B2) constituting part of said resonant cavity of the associated pump. the two pump filters presenting a mutual difference that gives rise to an offset between the two spectrum bands occupied by the two pump waves, thereby constituting two respective pumping bands.

2. An amplifier according to claim 1, in which the two pump filters cause the two pumping bands to be separate.

3. An amplifier according to claim 1, in which the stimulated emission medium of each pump (P1, P2) is limited firstly between an outlet face (T1, T2) connecting said medium to the pump injection fiber (F1, F2) associated with the pump, and secondly a reflection face (R1, R2) having higher reflectance than said outlet face.

4. An amplifier according to claim 3, in which the stimulated emission structure of each pump (P1, P2) is constituted by a semiconductor laser diode, said diode being provided with a leader fiber in which the filter of the pump (B1, B2) is provided.
